Europäisches Patentamt

European Patent Office

Office européen des brevets

(11) Publication number: **0 139 030**
**B1**

# EUROPEAN PATENT SPECIFICATION

(45) Date of publication of patent specification: **09.08.89**

(51) Int. Cl.⁴: **H 05 K 1/05**

(21) Application number: **83110437.7**

(22) Date of filing: **19.10.83**

(54) Improved printed circuit board.

(43) Date of publication of application:
**02.05.85 Bulletin 85/18**

(45) Publication of the grant of the patent:
**09.08.89 Bulletin 89/32**

(84) Designated Contracting States:
**DE FR GB IT NL**

(56) References cited:
**EP-A-0 092 020**
**FR-A-2 180 635**
**FR-A-2 263 208**
**GB-A-1 349 671**

(73) Proprietor: **Olin Corporation**
**427 North Shamrock Street**
**East Alton Illinois 62024 (US)**

(72) Inventor: **Butt, Sheldon H.**
**1904 Arrowhead Lane**
**Godfrey Illinois 62035 (US)**

(74) Representative: **Klunker, Hans-Friedrich, Dr.**
**et al**
**Patentanwälte Klunker . Schmitt-Nilson . Hirsch**
**Winzererstrasse 106**
**D-8000 München 40 (DE)**

Courier Press, Leamington Spa, England.

EP 0 139 030 B1

# Description

While the invention is subject to a wide range of applications, it is especially suited for use in printed circuit board applications and will be particularly described in that connection.

The printed circuit industry produces most printed circuits by adhering one or more layers of copper foil to organic materials such as glass fiber reinforced epoxy, phenolic laminated paper, polyester films, polyimide films, etc. Although widely used, these structures have certain deficiencies. Firstly, their maximum operating temperature is restricted by the maximum temperature tolerance of the organic substrate used. Secondly, a substantial mismatch usually exists between the coefficient of thermal expansion of the organic substrate and that of the copper foil, that of the solder compositions normally used to attach components to the circuitry and that of the components themselves. The coefficient of thermal expansion of the organic materials is normally substantially greater than that of the copper foil, the solder or the components being attached to the circuit. This mismatch results in substantial "thermal stresses" whenever the finished product is thermally cycled. These stresses create a variety of failure modes, such as tensile failure of the copper foil, failure of the solder attachment of components of the circuit and tensile failure of the components themselves.

To alleviate some of the problems associated with thermal stress, the industry uses two distinct types of metal core boards. One is an epoxy or other organic insulation over the metal core (either steel or aluminum), and the other is porcelain enameled steel.

The most popular is the metal core-organic type. Typically, the metal core, such as 1.27 mm (.050") thick aluminum, is drilled with oversized holes. As the core is coated with epoxy, the holes are filled with the epoxy. Copper foil is then bonded to one or both surfaces of the core. The holes are redrilled to a desired size and a liner of the epoxy (or other organic) is left to each hole. The finished metal core board compares to and may be processed as a standard plastic board. This may include electroless deposition of copper in the holes to provide current paths from top to bottom, etc. Better heat dissipation is provided by the metal core board as compared to the glass fiber reinforced epoxy type boards with rather poor thermal conductivity.

The second type of board, porcelain enameled steel, is considered either a metal core board or a metal clad board depending on the terminology. First, procelain enamel (essentially a glassy material) is applied to a sheet of steel. A circuit pattern is screen printed on the surface of the procelain enamel with one of the thick film "conductive inks" and the board is refired to create a continuous pattern of metallic conductive elements. Through-holes cannot be used due to problems with short circuiting and, therefore, multi-layer boards are not manufactured in this manner. The porcelain (glass) is rather thick and its thermal conductivity is relatively poor; in fact, it is even poorer than the thermal conductivity of plastics used in plastic boards or as a coating in metal core boards described above. It follows that the heat dissipation characteristics of the porcelain board are poor.

Conductive ink technology usually requires multiple applications of the conductive ink to build a conductor pattern which is thick enough to carry a desired electric current. The multiple screening and firing operations used in applying the conductive ink tend to be relatively complicated and expensive.

Presently, there is an increase in the circuit density of printed circuit boards. This creates a need for narrower and more clearly spaced "wires" or lines on the printed circuit board. The minimum line width generated by the state of the art conductive ink technology is limited by the printing process for applying the conductive ink. Also, the final conductive ink (generally either copper- or silver-) porcelain-steel product frequently has problems relating to the metallized pattern. The pattern may have a substantially different (higher) coefficient of thermal expansion than the steel substrate. This causes a substantial shear force at the circuit-porcelain interface and substantial risk of failure during thermal cycling.

Many of the above-mentioned considerations regarding clad metal are described in a paper entitled "Clad Metal Circuit Board Substrates for Direct Mounting of Ceramic Chip Carriers" by Dance and Wallace and presented at the First Annual Conference of the International Electronics Packaging Society, Cleveland, Ohio, 1981. Also, an article entitled "Use of Metal Core Substrates for Leadless Chip Carrier Interconnection" by Lassen in *Electronic Packaging and Production*, March 1981, pages 98—104, discusses the latest technology in metal core substrates.

Presently, copper foil is adhered to an organic printed circuit substrate by electrodeposition of "coral copper" to the foil surface. The result is a rough surface with re-entrance cavities to receive the surface layer of the organic substrate and/or the organic adhesive to form a "locked" mechanical bond. Since the surface layer is a conductive metal structure (copper) embedded in the organic material, considerable care must be exercised to remove any residual coral copper treatment from the spaces between the final printed circuit lines. This avoids unwanted current passing between lines, bridging of solder across the spaces between lines, etc. In principal, removal of residual coral copper treatment from areas requires additional etching beyond that required to remove the base foil itself. This excessive etching leads to additional undercutting and partial destruction of the circuit pattern. Thus, the manufacturer of conventional copper foil-organic circuit boards must strike a balance between enough etching to reliably remove the coral copper treatment while minimizing excessive etching to prevent undercutting of the circuit pattern.

The increased complexity of circuitry for interconnecting various devices mounted upon a printed circuit board often requires that both surfaces of the board contain conductive patterns. Some of the interconnections are provided by the circuit pattern on the obverse face of the board (the surface to which the components are mounted), while other interconnections are provided upon the reverse side of the board. The interconnection between the obverse and reverse sides of the board may be provided by solder filled through-holes. Conventional two sided copper foil-organic boards of this general configuration are widely used. However, in state of the art porcelain enameled steel substrate boards, two sided boards are not practical since the solid and continuous steel substrate creates a continuous path for electrical conduction from one through hole to another.

In certain applications, the circuit requirements include a double sided or multi-layered board in which thermal exposure or other factors prevent the use of a copper foil-organic board. An alternative is a metal circuit pattern on both sides of a suitable ceramic, non-conductive substrate with interconnection between the two circuits by conductive through-holes. This technique is used on specialized printed circuit boards and upon substrates for hybrid packages.

As integrated circuits become larger (more individual functions on a single silicon chip), and there is a corresponding increase in the number of leads for interconnection, the principal means of integrated circuit interconnection, the dual-in-line (DIP) package becomes impractical. A DIP includes a lead frame with the leads emerging from the package and formed into "pins". As its name indicates, the DIP package has two rows of pins, one on either side of the package. The pins are inserted and soldered into holes in a printed circuit board. Characteristically, the pins are spaced apart on 2.54 (.100") centers. A relatively simple device requiring a 20 lead package, 10 on a side, will be approximately 25.4 mm (1") long. A 40 lead DIP package is about 50.8 mm (2") long and a 64 lead DIP package, about the largest now made, is approximately 81.3 mm (3.2") long. For reasons relating to geometry, as the packages become longer with more pins, they become wider. Typically, the width of the completed package is approximately one-third its length. For both mechanical and electronic reasons, DIP packages with more than 64 leads are considered impractical to manufacture. However, large-scale integrated circuits often require more interconnections than provided by DIP packages. Evgen with smaller integrated circuits, the circuits are spaced together on the printed circuit board as closely as possible. Obviously, the package size limits the closeness of the spacing. Therefore, the semiconductor industry has a growing interest in "chip carriers".

Chip carriers deal with the problems of large-seals circuits requiring more interconnections than provided by a DIP package as well as reduction of package size for intermediate sized integrated circuits to increase component density on the printed circuit board. The term chip carrier, in its broadest sense, relates to packages, both ceramic and plastic. The configuration of a chip carrier may be essentially square and leads emerge from within the package on all four sides. Furthermore, typical center-to-center spacing of leads on a chip carrier is 1.27 mm (.050"). Thus, a 64 lead device having a "footprint" of roughly 82.6 mm×27.9 mm (3.25"×1.1") in a DIP package has a "footprint" of approximately 20.3mm×20.3 mm (0.8"×0.8") in a chip carrier package. More importantly, the area covered by the chip carrier would be approximately 18% of that covered by the DIP package. At this time, chip carrier packages with 128 and more leads are being produced.

The principal constraint in establishing 2.54 mm (.100") as the normal spacing between leads on the DIP package is the insertion of the lead pins into holes on the printed circuit board. Allowing for the hole, a pad area around the hole for solder adhesion and spacing between the holes to electrically isolate them from each other, it becomes difficult to crowd them much closer together.

Typically, the coefficient of thermal expansion of the DIP package is different from that of the printed circuit board. The extent to which board and package dimensions change with varying temperature can be accommodated by deflection of the leads, i.e. between the printed circuit board and the package. Effectively, the leads become spring members which accommodate the differences in coefficient of expansion.

State of the art chip carriers having 1.27 mm (.050") leads are not normally mounted by insertion of the leads into holes in the printed circuit boards. Instead, most chip carriers use a surface mounting technique in which the lead forms a pad mounted flush to the printed circuit board and is soldered in place. The metallized pads on the exterior surface of the chip package are integral with the package and expand and contract with the package. There is no accommodation for deflection of leads due to changes in board and package dimensions, as in the case of DIP passages, during thermal cycling. As a result, the solder bond between the pad and the board is subjected to substantial stresses. The stresses increase as the total package size becomes larger and/or the board's operation is in an expanded temperature range. Repeated stressing of the solder bond leads to fatigue failure.

In with DIP packages, chip carrier packages may use a plastic package or may require a hermetic package. With the DIP package, essentially the same external configuration is employed for a hermetic (Ceramic Dual-In-Line Package) or a plastic package. In both configurations, the flexible leads accommodate for differential thermal expansion.

The "standard" glass cloth reinforced epoxy board material has a coefficient of thermal expansion of $15.8\times10^{-6}/^{\circ}C$. Ceramic chip carriers usually made from an aluminum oxide ceramic have a coefficient of thermal expansion of $6.4 \times 10^{-6}/°C$. If thermal conductivity is particularly important, they may be made from beryllium oxide also having a coefficient of thermal expansion of $6.4 \times 10^{-6}/°C$. In either event, there is a substantial mismatch in coefficient of thermal expansion between the board and the chip carrier. Therefore, substantial stresses are imposed on the solder bond when subjected to significant thermal cycling.

One solution has been to surface mount the chip carrier to a metallized pattern on an aluminum oxide ceramic substrate. The substrate has the same coefficient of thermal expansion at the chip carrier. Pins may be brazed to the alumina substrate and plugged into holes in the printed circuit board. Although this sort of configuration avoids problems associated with mismatch in coefficient of thermal expansion, it also has the effect of sacrificing much of the space saving advantages of the chip carrier.

A description of the latest technology with respect to chip carrriers is presented in an article entitled "Chip-Carriers, Pin-Grid Arrays Change the PC-Board Landscape" by Jerry Lyman, *Electronics*, December 29, 1981, pages 65—75. Another article entitled "Chip Carriers: Coming Force in Packaging" by Erickson, in *Electronic Packaging and Production*, March 1981, pages 64—80 discusses the construction and other details concerning chip carriers.

U.S. Patent No. 3,546,363 to Pryor et al. discloses a composite metal product for use as a seal to glasses and ceramics which has properties of a low coefficient of expansion, approximating that of the appropriate glasses and ceramics, good thermal conductivity, and fine grain size in the annealed condition.

U.S. Patent Nos. 3,546,363; 3,618,203; 3,676,292; 3,726,987; 3,826,627; 3,826,629; 3,837,895; 3,852,148; and 4,149,910 disclose glass or ceramic to metal composites or seals wherein the glass or ceramic is bonded to a base alloy having a thin film of refractory oxide on its surface.

The present invention relates to a composite adapted to be a printed circuit board system, comprising:
a first metal or alloy component;
a second metal or alloy component;
a glass or ceramic component disposed between said first component and said second component for bonding the first and second components to each other;
said glass or ceramic component further having a coefficient of thermal expansion being close to the coefficient of thermal expansion of said first and second components whereby thermal stress between the first, second and glass or ceramic components may be substantially eliminated.

Such a composite is disclosed in EP—A—0 092 020 which was published after the filing date of the present patent and falls under Art. 54(3) EPC. The various embodiments of the known composite all comprise thin refractory oxide layers, preferably consisting of $Al_2O_3$, on the surfaces bonded to the glass or ceramic component.

In contrast thereto, in the composite according to the present invention at least one of said first and second components has a non-refractory oxide layer on its bonding surface or each of the first and second components is directly bonded to said glass or ceramic component without an interface oxide layer therebetween.

The present invention further relates to a process of forming a composite adapted to be a printed circuit board system, comprising:
providing a first metal or alloy component;
providing a second metal or alloy component;
disposing a glass or ceramic component between said first and second components, said glass or ceramic component having a coefficient of thermal expansion close to the coefficient of thermal expansion of said first and second components whereby thermal stress between the first, second and glass or ceramic components may be substantially eliminated; and
bonding said first, second and glass or ceramic components together,
wherein at least one of said first and second components is bonded to its adjacent component with a non-refractory oxide surface layer or each of said first and second components is bonded directly without an interface oxide layer therebetween.

Preferred embodiments of the invention are claimed in dependent claims.

The invention and its preferred embodiments provide a number of advantages, in particular: A printed circuit board which can accommodate substantial thermal cycling; a composite which obviates one or more of the limitations and disadvantages of the described prior arrangements; a composite which substantially reduces the formation of stresses between the circuit and the substrate due to thermal cycling; a composite which is relatively inexpensive to manufacture; a composite having improved heat dissipation.

The glass or ceramic component may serve to electrically insulate the first and second components and/or to provide rigidity to the composite. The composite may be formed as a multi-layer composite comprising three or more metal or metal base alloys components and two or more glass or ceramic components.

The invention will now be elucidated by means of preferred embodiments shown in the drawings; by omitting the described non-refractory oxide layers alternative embodiments are formed in which the glass or ceramic component and the first and second components are directly bonded to each other without an interface layer therebetween:

Figure 1 is a cross section of a prior art printed circuit board;

Figure 2 is a cross section of a metal core prior art printed circuit board;

Figure 3 is a cross section of a printed circuit board having a glass component bonded between the oxide coating of two copper alloys;

Figure 4 is a printed circuit board having high thermal conductivity substrates bonded to copper alloy components;

Figure 5 is a cross-sectional view of a printed circuit board with a fused oxide layer between two substrates;

Figure 6 is a printed circuit board having circuits on opposite surfaces and interconnections therebetween;

Figure 7 is a cross-sectional view of a printed ciruit board having circuits on opposite surfaces and a metal grid therebetween;

Figure 8 is a top view of a metal grid used for reinforcement of a printed circuit board;

Figure 9 is a view through 9—9 of Figure 8;

Figure 10 is a side view of a multi-layer printed circuit board;

Figure 11 is a side view of a leadless chip carrier;

Figure 12 is a top view of the chip carrier of Fig. 11; and

Figure 13 is a side view of a leadless chip carrier mounted upon a printed circuit board.

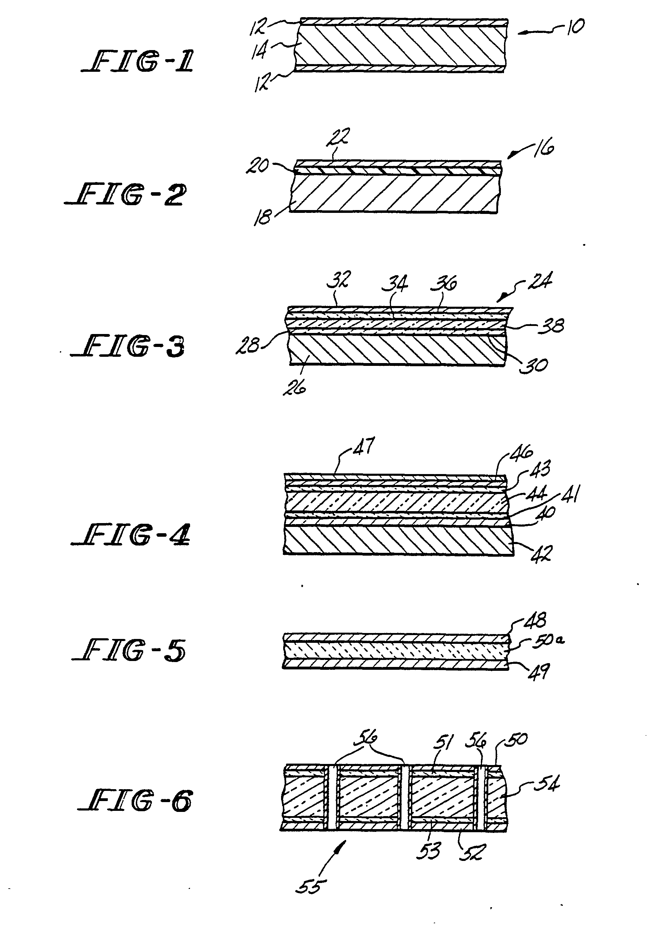

As shown in Figure 1, prior art printed circuits 10 are produced by adhering one or more layers of copper foil 12 to organic material 14 such as glass fiber reinforced epoxy, phenolic laminated paper, etc. These structures have several deficiencies including restricted maximum operating temperature due to the organic substrate and substantial mismatch between the coefficient of thermal expansion of the organic substrate and that of the copper foil, the solder compositions to attach components to the circuitry and the components themselves. Substantial thermal stresses, resulting from the mismatch, create failure modes such as tensile failure of the copper foil, failure of the solder attachment of components to the circuit and tensile failure of the components themselves.

There is some use of metal core boards 16 found in Figure 2. Typically, these include a metal core 18, a copper foil 22 and an epoxy insulating layer 20 bonded to both metal core 18 and foil 22. This type of board provides better heat dissipation than the normal glass fiber reinforced epoxy boards but still has the restricted maximum operating temperature related to the organic substrate. Also, substantial mismatch between the coefficient of thermal expansion of the organic substrate and the copper foil causes the types of problems associated with conventional printed circuits as shown in Figure 1.

In accordance with one aspect of present invention these problems are overcome by providing a composite or printed circuit board 24 substantially as shown in Figure 3. The composite includes a first metal or metal base alloy component 26 having a thin non-refractory oxide layer 28 on at least a first surface 30 thereof and a second thin non-refractory oxide layer 34 on at least surface 36 of a second metal or metal base alloy component 32. A glass component 38 is bonded to the first and second thin non-refractory oxide layers 28 and 34 to insulate the first component 26 from the second component 32. The non-refractory oxide layers 28 and 34 consist preferably of copper oxides.

The present invention uses any suitable glass or ceramic component 38, such as cited in the patents above, with a coefficient of thermal expansion which closely matches that of the metal components. The glass is bonded to the thin non-refractory oxide layers 28 and 34 and functions to adhere the metal components together and electrically insulate them from each other. Since the glass and the coper alloy substrates have the same or closely matched coefficients of thermal expansion, thermal stresses in the system may be essentially eliminated and the problems associated with thermal stress in the finished product alleviated.

Table I lists various exemplary glasses and ceramics which are adapted for use in composites according to this invention.

TABLE I

| Glass or Ceramic Type | Coefficient of Thermal Expansion, /°C |
|---|---|
| Ferro Corp.[1] No. RN-3066-H | $167 \times 10^{-7}$ |
| Ferro Corp.[1] No. RN-3066-S | $160 \times 10^{-7}$ |

[1]Proprietary composition manufactured by Ferro Corporation, Cleveland, Ohio.

Referring again to the embodiment as illustrated in Figure 3, a foil layer 32 is bonded to a thicker supportive layer 26 by means of glass 38. The foil 32 may be subsequentially treated with a "resist" pattern and etched to produce a printed circuit. The result is a wrought copper alloy circuit pattern bonded to and insulated from a wrought copper alloy supportive substrate 26 by a layer of glass 38 which serves as both an adhesive and an insulating material. This configuration has a number of advantages over the prior technique of printing circuitry upon the surface of porcelain with conductive ink. Firstly, in the prior conductive ink technology, multiple layers of the conductive ink are applied to provide an adequate conductive pattern for the required electric current. However, the circuit foil 32 may be of any desired thickness and replaces the multiple screening and firing operations by a single firing operation and a single etching operation. Secondly, recent increases in circuit density of printed circuit boards create a need for narrower and more closely spaced printed "wires" or lines. The prior conductive ink technology is limited to the minimum line width generated by the printing process. According to the embodiment, however, etched copper foil is used which provides narrow lines and spaces as in conventional etched copper foil, organic substrate circuits. Thirdly, the metallized pattern formed on the conductive ink-porcelain-steel circuit board has a substantially higher coefficient of thermal expansion than the steel substrate. Thermal cycling develops substantial shear forces at the circuit-porcelain interface creating substantial risk of failure. The embodiment of Figure 3 substantially eliminates these shear forces because the coefficient of thermal expansion of the circuit foil and the metal substrate are substantially the same.

Where greater conductivity than that inherent in the metal or alloys producing bondable films is desired, a composite copper alloy foil incorporating a higher conductivity layer, as shown in Figure 4, may replace the solid alloy 32 as in the previous embodiment.

The embodiment of Figure 4 includes bondable copper alloy substrate 40 and circuits foil 46 having non-refractory oxide layers 41 and 43, respectively. A glass or ceramic 44 is bonded between the oxide layer 43 on circuit foil 46 and the oxide layer 41 on the copper base alloy 40. Substrate 40 is bonded, as a composite, to a copper or high conductivity copper alloy thicker component 42. The latter provides for superior thermal dissipation from the board as compared to both conventional copper foil-organic boards and porcelain on steel boards. Also, foil 46 may be bonded as a composite to a copper or high conductivity copper alloy component 47 for superior electrical or thermal conductivity. It is also possible to provide only one of the components 42 or 47 as required. It is further possible to modify any of the described embodiments by bonding the component, as a composite, to a metal layer having desired physical properties.

The embodiment as shown in Figure 5 provides copper alloy substrates 48 and 49 each forming a non-refractory oxide layer. These non-refractory oxide layers are fused together into layer 50a and dispense with the provision of glass. The unified non-refractory oxide layer 50a both adheres the metal substrates 48 and 49 and insulates them from each other. It is in compliance with the teaching of the invention to substitute the glass in the embodiments of the present invention with fused non-refractory oxide layers as desired.

The complexity of the circuitry for interconnecting the various devices mounted upon a printed circuit board often requires that both surfaces of the board contain conductive patterns. Details of prior art two sided circuit boards are described above.

·A two sided circuit board configuration 55, as shown in Figure 6, has two relatively thick layers of copper base alloy components 50 and 52, each having a thin non-refractory oxide layer 51 and 53, respectively, on at least one surface. The components are bonded together and insulated from one another by a glass or ceramic 54 which is fused to the oxide layers 51 and 53. A circuit pattern is formed on each of the components 50 and 52 by a conventional technique. The thickness of each metal component is established in accordance with the desired stiffness of the finished board. The circuit patterns on each side of the board 55 must be carefully designed to provide reasonable stiffness and to avoid planes of weakness. Such planes might develop if an area of considerable size without any circuitry on one side of the board coincides with a similar area on the reverse side of the board. Through-holes 56 may be provided in the circuit board by any conventional technique such as drilling or punching. The through-holes may be formed into a conductive path by any suitable means such as electroless deposition of copper on their walls. If desired, the through-holes can then be filled with a conductive material such as solder.

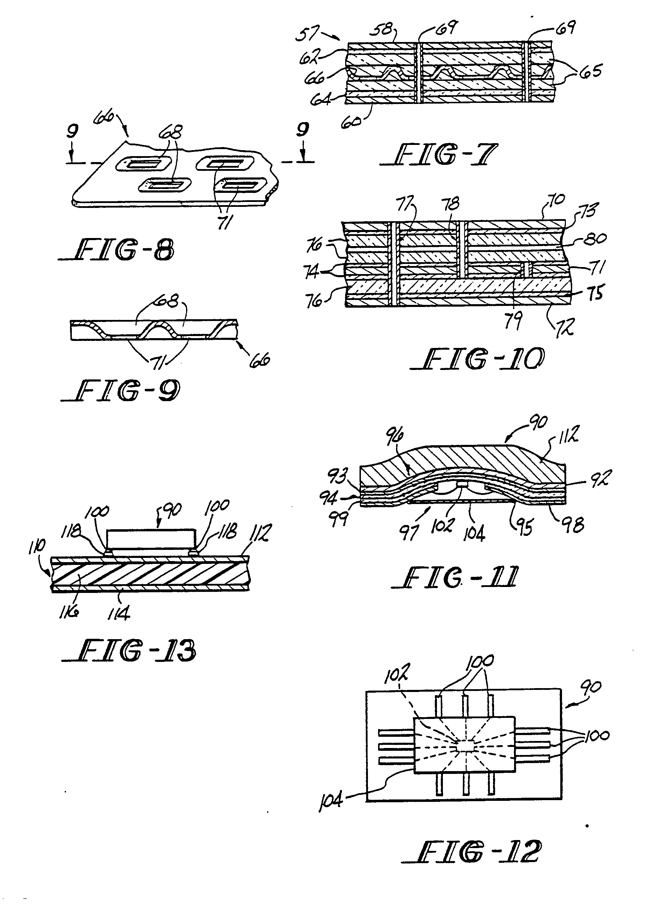

Another embodiment of a two sided metal glass printed circuit board 57, as shown in Figure 7, includes two copper alloy substrates 58 and 60, each having a thin non-refractory oxide layer 62 and 64, respectively, bonded on at least one surface. A glass component 65 is fused to the layers 62 and 64. A grid 66, preferably metal, is bonded in the glass 65 and insulated from the alloy substrates 58 and 60. The recesses 68 of the grid may be filled with glass 65 or any other suitable inorganic filler. Through-holes 69 are formed in the board as described above. The result is a board with the same design flexibility as conventional foil-organic boards but with the advantage of substantial elimination of thermal stresses. The metal grid both stiffens the board 57 and permits a plurality of through-holes 69 to pass through openings 68 of the grid. The through-holes must not contact the metal grid to avoid short circuits.

The metal grid is preferably made of a copper alloy having a thin non-refractory oxide layer on both surfaces. It is, however, possible to use any desired material to construct the grid. The grid may be formed with any desired configuration, and a typical one is shown in Figure 8. A series of recesses 68 are stamped in a metal sheet 67. Subsequently, the bottom 71 of the recesses are pierced leaving a pattern of interlocking "V" bars, as shown in Figure 8, for reinforcement.

The need for still greater circuit complexity than provided by a two sided circuit board leads to multilayer circuit boards with three or more layers of copper foil. Using the concepts described hereinabove, a multi-layer board composed of alternate layers of copper alloy foil having a thin non-refractory oxide layer on each surface in contact with the glass insulator is described. As shown in Figure 10, copper foil components 70, 71 and 72 have their non-refractory oxide layers 73, 74 and 75, respectively, bonded to glass 76. The foil components may each be provided with circuitry as in the embodiments described above. Also, the components may be bonded as composites to other metals with desired physical properties as described above. It is thought that the thicker multi-layer boards will be sufficiently rigid. Where additional rigidity is required, grid reinforcement as described and illustrated in Figure 7 may be added. Also, through-holes 77, 78 and 79 between the circuits, as described above, may be provided as necessary. Note that the through-holes may be between any number of circuits.

Since the power consumption of most board mounted electronic components is quite modest, the heat generated during their operation is comparably small. However, as packaging density becomes greater, more elaborate means for cooling must be provided. A preferred embodiment of the present invention provides for cooling of the multilayer printed circuit boards, as shown in Figure 10, by bonding high thermal conductivity layers of copper alloy to the circuit foil, as in Figure 4. This layer of copper alloy functions to conduct heat from the board. It is possible to provide one or more layers of conductive material 80 within the multi-layer board. Material 80 may be a solid strip of high thermal conductivity material such as copper or copper alloy. It may be desirable to use a copper alloy having a non-refractory oxide layer for improved bonding to the glass 76. Naturally, any through-holes may require insulation from the strip 80. The conductive material 80 may comprise one or more tubular members embedded in the glass to provide coolant passages. Again, it is preferable that the copper tubing have a thin non-refractory layer on its surface to bond to the glass.

Another preferred embodiment of the present invention resides in the provision of a leadless ceramic chip carrier which can be directly mounted to the surface of a printed circuit board. This chip carrier substantially eliminates excessive stressing of the solder bond to the circuit board which generally occurs during thermal cycling of the chip carrier-printed circuit board systems as described hereinabove. Referring to Figures 11 and 12, there is illustrated a leadless chip carrier 90 wherein a copper alloy 92 with a thin non-refractory oxide layer 93, such as a copper oxide, provided on one surface thereof is substituted for the prior art alumina or beryllia ceramic. A glass 94 may be fused onto the oxide layer as described above. It is, however, possible to use only the non-refractory oxide layer. As can be seen in Figure 11, the copper alloy 92 may be shaped with a slight indentation 96, exaggerated in the drawing to better clarify the concept. The indentation can be formed in any desired configuration. A metal foil 98, which may be formed of the same material as 92, having a non-refractory oxide layer 99, is bonded to the glass 94 or the non-refractory oxide layer 93 and etched in any conventional manner to provide electrical leads 100. A chip 102 is preferably attached to the glass 94 by any conventional technique and lead wires connect between the circuitry on the chip and the leads 100.

The chip may be sealed within the indentation 96 by several techniques. Preferably, the sealing device 97 may be a cover plate 104 comprising a copper or copper base alloy having a thin non-refractory oxide layer thereon. Glass 95 is fused onto at least the edges of the cover 97. This glass can be bonded to either the non-refractory oxide layer 99 on the component 98 or to the glass 94 as required. The result is to hermetically seal the chip 102 in the leadless chip carrier 90. Another embodiment provides the seal by filling the indentation 96 with an epoxy. The epoxy will bond to the leads and the glass and provides an adequate but not necessarily hermetic seal.

Referring to Figure 13, the leadless chip carrier 90 is affixed to a typical printed circuit board 110. This board has copper foil 112 and 114 separated by glass cloth reinforced epoxy 116. A circuit is provided on the foil 112. The leadless chip carrier may be applied directly into the circuitry of strip 112 by solder pads 118 between the lead 100 and the foil 112 in a conventional manner.

The surface mounted hermetic chip carrier as described above and illustrated in Figure 12 will resolve most of the normal problems associated with the effect of thermal cycling of a chip carrier that is surface mounted to a conventional glass cloth reinforced epoxy printed circuit board. However in some cases, a closer match of coefficient of thermal expansion may be required and/or greater heat dissipation capability may be necessary. In these cases, a metal board configuration of the types described hereinabove and illustrated in Figures 2—7 and 10 may be substituted for the conventional printed circuit board.

In one embodiment, reduced mismatch of thermal expansion and greater heat dissipation can be achieved by mounting a chip carrier of the type illustrated in Figures 11 and 12 on a prior art printed circuit board as shown in Figure 2 where the core is copper or a high conductivity copper alloy. An alloy may be desirable if greater strength is required than may be provided with pure copper. A suitable plastic insulating layer 20 is appropriately bonded to the copper or copper alloy core and in turn, the printed circuit foil 22 is bonded to the insulating layer. The plastic must be suitable for bonding with adhesives, have suitable dielectric characteristics and the ability to withstand processing temperatures such as soldering. The thermally conductive plastics may be particularly useful for the plastic layer. These plastics typically contain metal powders to improve their thermal conductivity while maintaining dielectric properties since the metal powders are not in a continuous phase. Since the plastic is only thick enough to provide the necessary dielectric properties, resistance to heat transfer from the chip carrier to the high conductivity copper or copper alloy core is minimized. It can be appreciated that the coefficient of thermal expansion of the metal board is essentially the same as that of the glass coated chip carrier and, therefore, stresses induced by thermal cycling of the system are substantially eliminated. This configuration is limited by the temperature capability of the plastic or plastics and the temperature resistance of the adhesives which are used in conjunction with the plastics.

To improve the maximum temperature capability of the leadless chip carrier and printed circuit board combination, a printed circuit board as illustrated in Figure 3 may be used in conjunction wiht the leadless chip carrier 90 shown in Figure 11. In this configuration, the metal core consists of copper or a high conductivity copper alloy 26 to which is clad a glass bondable copper alloy. In turn, a printed circuit foil 32 consisting of a glass bondable copper alloy is bonded to the glass 38. The copper or higher conductivity copper alloys are selected so as to improve the electrical conductivity in the circuit or to provide optimum solderability characteristics. The system is completely inorganic and will withstand temperatures much higher than systems with organic materials and further avoids various modes of degradation to which organic materials are susceptible.

An additive circuit may be substituted for photoetched foil 48 in Figure 5. The circuit may be generated upon a glass coating applied to the non-refractory oxide layer or other glass bondable alloy core material 49 using conventional techniques employed in generating additive circuits. For example, the additive circuit may be a pattern printed upon the surface of the glass with conductive ink and fired into place. It is also possible for the non-refractory oxide film which may be formed by heating the alloy to be used as the dielectric layer separating the metal core from the additive circuit.

Whereas non-refractory oxide layer has been described as being formed by separately heating the metal or alloy, it may be formed in any manner such as during the process of bonding the metal or alloy to the glass, ceramic or another oxide layer.

Whereas the chip carrier has been described as leadless, it is also possible to substitute a chip carrier with leads.

## Claims

1. A composite (24; 55; 57; 90) adapted to be a printed circuit board system, comprising:
a first metal or alloy component (26; 40; 49; 52; 60; 72; 98);
a second metal or alloy component (32; 46; 48; 50; 58; 70; 92);
a glass or ceramic component (38; 44; 54; 65; 76; 94) disposed between said first component and said second component for bonding the first and second components to each other;
said glass or ceramic component further having a coefficient of thermal expansion being close to the coefficient of thermal expansion of said first and second components whereby thermal stress between the first, second and glass or ceramic components may be substantially eliminated, and wherein at least one of said first and second components has a non-refractory oxide layer (28; 41; 50a; 53; 34; 43; 51; 62; 73; 93) on its bonding surface or each of said first and second components is directly bonded to said glass or ceramic component without an interface oxide layer therebetween.

2. The composite as in claim 1 characterized by said first and second metal or alloy components being copper or a copper alloy.

3. The composite (24; 55; 57; 90) as in claim 2, characterized by said non-refractory oxide layer (28; 41; 50a; 53; 34; 43; 51; 62; 73; 93) being a copper oxide layer.

4. The composite (24; 55; 57; 90) as in claim 2 or 3, characterized by said first copper or copper base alloy component (26; 40; 49; 52; 60; 72) being a first thin foil having a first electrical circuit pattern thereon.

5. The composite (24; 55; 57) as in claim 4 characterized by said second copper or copper base alloy component (32; 46; 48; 50; 58; 70) being a second thin foil having a second electrical circuit pattern thereon.

6. The composite (55; 57) as in claim 5 further characterized by conductive means (56; 69; 77; 78; 79) disposed in said glass or ceramic component and extending between said first and second components for electrically interconnecting said first and second electrical circuit patterns.

7. The composite (57) as in any one of claims 1 to 6, characterized by grid means (66) embedded in said glass or ceramic component for stiffening said composite.

8. The composite (57) as in claim 7 characterized by said grid means (66) further including:
a plurality of recesses (68) extending from a surface of said grid means, one or more of said recesses having an opening extending therethrough; and
said bonding means disposed so as to extend through said one or more openings.

9. A process of forming a composite (24; 55; 57; 90) adapted to be a printed circuit board system, comprising:
providing a first metal or alloy component (26; 40; 49; 52; 60; 72; 98);
providing a second metal or alloy component (32; 46; 48; 50; 58; 70; 92);
disposing a glass or ceramic component (38; 44; 54; 65; 76; 94) between said first and second components, said glass or ceramic component having a coefficient of thermal expansion close to the coefficient of thermal expansion of said first and second components whereby thermal stress between the first, second and glass or ceramic components may be substantially eliminated; and
bonding said first, second and glass or ceramic components together,
and wherein at least one of said first and second components is bonded to its adjacent component with a non-refractory oxide surface layer (28; 41; 50a; 53; 34; 43; 51; 62; 73; 93) or each of said first and second components is bonded directly without an interface oxide layer therebetween.

10. The process as in claim 9 characterized by disposing one or more conductive means (56; 69; 77; 78; 79) in said glass or ceramic component for electrically interconnecting said first and second components.

11. The process as in claim 9 or 10, characterized by embedding grid means (66) in said glass or ceramic component for stiffening said composite.

## Patentansprüche

1. Verbundgebilde (24; 55; 57; 90), das ein gedrucktes Schaltungsplattensystem sein kann, mit:

einer ersten Komponente (26; 40; 49; 52; 60; 72; 98) aus Metall oder einer Legierung;

einer zweiten Komponente (32; 46; 48; 50; 58; 70; 92) aus Metall oder einer Legierung;

einer zwischen der ersten Komponente und der zweiten Komponente angeordneten Komponente (38; 44; 54; 65; 76; 94) aus Glas oder Keramik zum Verbinden der ersten und der zweiten Komponente miteinander;

wobei die Komponente aus Glas oder Keramik weiterhin einen Wärmeausdehnungskoeffizienten besitzt, der nahe bei dem Wärmeausdehnungskoeffizienten der ersten und der zweiten Komponente liegt, wodurch sich Wärmgespannungen zwischen der ersten und der zweiten Komponente sowie der Komponente aus Glas oder Keramik im wesentlichen eliminieren lassen, und wobei wenigstens eine der ersten und der zweiten Komponenten eine nicht hitzebeständige Oxidschicht (28; 41; 50a; 53; 34; 43; 51; 62; 73; 93) auf ihrer Verbindungsfläche aufweist oder jede der ersten und der zweiten Komponenten direkt mit der Komponente aus Glas oder Keramik verbunden ist, ohne daß eine Zwischenflächen-Oxidschicht dazwischen angeordnet ist.

2. Verbundgebilde nach Anspruch 1, dadurch gekennzeichnet, daß es sich bei der ersten und der zweiten Komponente aus Metall oder einer Legierung um Kupfer oder eine Kupferlegierung handelt.

3. Verbundgebilde (24; 55; 57; 90) nach Anspruch 2, dadurch gekennzeichnet, daß es sich bei der nicht hitzebeständigen Oxidschicht (28; 41; 50a; 53; 34; 43; 51; 62; 73; 93) um eine Kupferoxidschicht handelt.

4. Verbundgebilde (24; 53; 57; 90) nach Anspruch 2 oder 3, dadurch gekennzeichnet, daß es sich bei der ersten Komponente (26; 40; 49; 52; 60; 72) aus Kupfer oder einer Kupferbasislegierung um eine erste dünne Folie mit einem ersten elektrischen Schaltungsmuster handelt.

5. Verbundgebilde (24; 55; 57) nach Anspruch 4, dadurch gekennzeichnet, daß es sich bei der zweiten Komponente (32; 46; 48; 50; 58; 70) aus Kupfer oder einer Kupferbasislegierung um eine zweite dünne Folie mit einem zweiten elektrischen Schaltungsmuster handelt.

6. Verbundgebilde (55; 57) nach Anspruch 5, dadurch gekennzeichnet, daß eine leitfähige Einrichtung (56; 69; 77; 78; 79) in der Komponente aus Glas oder Keramik angeordnet ist und sich zur elektrischen Verbindung des ersten und des zweiten elektrischen Schaltungsmusters miteinander zwischen der ersten und der zweiten Komponente erstreckt.

7. Verbundgebilde (57) nach einem der Ansprüche 1 bis 6, dadurch gekennzeichnet, daß eine Gittereinrichtung (66) zum Versteifen des Verbundgebildes in die Komponente aus Glas oder Keramik eingebettet ist.

8. Verbundgebilde (57) nach Anspruch 7, dadurch gekennzeichnet, daß die Gittereinrichtung (66) weiterhin aufweist:

eine Mehrzahl von Aussparungen (68), die sich von einer Oberfläche der Gittereinrichtung wegerstrecken, wobei eine oder mehrere der Aussparungen eine sich durch diese hindurcherstreckende Öffnung aufweisen; und

die Verbindungseinrichtung, die derart angeordnet ist, daß sie sich durch die eine oder mehreren Öffnungen hindurch erstreckt.

9. Verfahren zur Bildung eines Verbundgebildes (24; 55; 57; 90), das ein gedrucktes Schaltungsplattensystem sein kann, umfassend:

Bildung einer ersten Komponente (26; 40; 49; 52; 60; 72; 98) aus Metall oder einer Legierung;

Bildung einer zweiten Komponente (32; 46; 48; 50; 58; 70; 92) aus Metall oder einer Legierung;

Anordnen einer Komponente (38; 44; 54; 65; 76; 94) aus Glas oder Keramik zwischen der ersten und der zweiten Komponente, wobei die Komponente aus Glas oder Keramik einen Wärmeausdehnungskoeffizienten besitzt, der nahe bei dem Wärmeausdehnungskoeffizienten der ersten und der zweiten Komponente liegt, wobei sich Wärmespannungen zwischen der ersten und der zweiten Komponente sowie der Komponente aus Glas oder Keramik im wesentlichen eliminieren lassen; sowie

Verbinden der ersten und der zweiten Komponente sowie der Komponente aus Glas oder Keramik miteinander;

wobei wenigstens eine der ersten und der zweiten Komponenten mit der ihr benachbarten Komponente mittels einer nicht hitzebeständigen Oxidschicht (28; 41; 50a; 53; 34; 43; 51; 62; 73; 93) verbunden wird oder jede der ersten und der zweiten Komponenten mit der ihr benachbarten Komponente direkt verbunden wird ohne eine Zwischenflächen-Oxidschicht dazwischen.

10. Verfahren nach Anspruch 9, dadurch gekennzeichnet, daß eine oder mehrere leitfähige Einrichtungen (56; 69; 77; 78; 79) in der Komponente aus Glas oder Keramik zum elektrischen miteinander Verbinden der ersten und der zweiten Komponente angeordnet werden.

11. Verfahren nach Anspruch 9 oder 10, dadurch gekennzeichnet, daß eine Gittereinrichtung (66) zum Versteifen des Verbundgebildes in die Komponente aus Glas oder Keramik eingebettet wird.

## Revendications

1. Matériau composite (24; 55; 57; 90) approprié à constituer un système de carte de circuit imprimé, comprenant:

un premier élément de métal ou d'alliage (26; 40; 49; 52; 60; 72; 98),

un second élément formé d'un métal ou d'un alliage (32; 46; 48; 50; 58; 70; 92),

un élément de verre ou de céramique (38; 44; 54; 65; 76; 94) placé entre le premier et le second élément et destiné à coller le premier et le second élément l'un à l'autre,

l'élément de verre ou de céramique ayant en outre un coefficient de dilatation thermique proche de celui du premier et du second élément, si bien que les contraintes thermiques formées entre le premier et le second élément et l'élément de verre ou de céramique peuvent être pratiquement éliminées, et

dans lequel l'un au moins des premier et second éléments a une couche d'un oxyde non réfractaire (28; 41; 50a; 53; 34; 43; 51; 62; 73; 93) à sa surface de collage ou chacun des premier et second éléments est directement collé à l'élément de verre ou de céramique sans couche intermédiaire d'oxyde d'interface.

2. Matériau composite selon la revendication 1, caractérisé en ce que le premier et le second élément de métal ou d'alliage sont formés de cuivre ou d'un alliage de cuivre.

3. Matériau composite (24; 55; 57; 90) selon la revendication 2, caractérisé en ce que la couche d'un oxyde non réfractaire (28; 41; 50a; 53; 34; 43; 51; 62; 73; 93) est une couche d'oxyde de cuivre.

4. Matériau composite (24; 55; 57; 90) selon la revendication 2 ou 3, caractérisé en ce que le premier élément de cuivre ou d'alliage à base de cuivre (26; 40; 49; 52; 60; 72) est une première feuille mince sur laquelle est formé un premier dessin de circuit électrique.

5. Matériau composite (24; 55; 57) selon la revendication 4, caractérisé en ce que le second élément de cuivre ou d'alliage à base de cuivre (32; 46; 48; 50; 58; 70) est une seconde mince feuille ayant un second dessin de circuit électrique formé sur elle.

6. Matériau composite (55; 57) selon la revendication 5, caractérisé en outre par un dispositif conducteur (56; 69; 77; 78; 79) disposé dans l'élément de verre ou de céramique et placé entre le premier et le second élément afin qu'il relie électriquement les premier et second dessins de circuits électriques.

7. Matériau composite (57) selon l'une quelconque des revendications 1 à 6, caractérisé par une grille (66) enrobée dans l'élément de verre ou de céramique afin qu'elle augmente la rigidité du matérriau composite.

8. Matériau composite (57) selon la revendication 7, caractérisé en ce que la grille (66) comporte en outre:

plusieurs cavités (68) formées dans une surface de la grille, une ou plusieurs des cavités ayant une ouverture qui la traverse, et

un dispositif de collage disposé de manière qu'il passe dans l'ouverture ou les ouvertures.

9. Procédé de formation d'un matériau composite (24; 55; 57; 90) approprié à constituer un système à carte de circuit imprimé, comprenant:

la dispositif d'un premier élément formé d'un métal ou d'un alliage (26; 40; 49; 52; 60; 72; 98),

la disposition d'un second élément forme d'un métal ou d'un alliage (32; 46; 48; 50; 58; 70; 92),

la disposition d'un élément de verre ou de céramique (38; 44; 54; 65; 76; 94) entre le premier et la second élément, l'élément de verre ou de céramique ayant un coefficient de dilatation thermique proche de celui du premier et du second élément et bien que les contraintes thermiques peuvent être pratiquement éliminées entre le premier et le second élément et l'élément de verre ou de céramique, et

le collage du premier et du second élément et de l'élément de verre ou de céramique les une sur les autres, et

dans lequel l'un au moins des premier et second éléments est collé à l'élément adjacent par une couche superficielle d'un oxyde non réfractaire (28; 41; 50a; 53; 34; 43; 51; 62; 73; 93) ou chacun des premier et second éléments est colié directement sans couche intermédiaire d'oxyde d'interface.

10. Procédé selon la revendication 9, caractérisé par la disposition d'un ou plusieurs dispositifs conducteurs (56; 69; 77; 78; 79) dans l'élément de verre ou de céramique de manière que le premier et le second élément soient interconnectés électriquement.

11. Procédé selon la revendication 9 ou 10, caractérisé par l'enrobage d'une grille (68) dans l'élément de verre ou de céramique de manière que la rigidité de matériau composite soit accrue.

FIG-1

FIG-2

FIG-3

FIG-4

FIG-5

FIG-6

FIG-7

FIG-8

FIG-9

FIG-10

FIG-11

FIG-13

FIG-12